## Europäisches Patentamt

## European Patent Office

## Office européen des brevets

(19)

(11) Veröffentlichungsnummer: **0 372 421**

**A2**

(12)

# EUROPÄISCHE PATENTANMELDUNG

(21) Anmeldenummer: **89122222.6**

(22) Anmeldetag: **01.12.89**

(51) Int. Cl.⁵: **H01L 33/00, H01S 3/19**

(30) Priorität: **02.12.88 DE 3840717**

(43) Veröffentlichungstag der Anmeldung:
**13.06.90 Patentblatt 90/24**

(84) Benannte Vertragsstaaten:
**DE FR GB IT NL**

(71) Anmelder: **Max-Planck-Gesellschaft zur Förderung der Wissenschaften e.V.**
**Bunsenstrasse 10**
**D-3400 Göttingen(DE)**

(72) Erfinder: **Lobentanzer, Hans, Dr.**
**Julius-Kreis-Strasse 18**
**D-8000 München 60(DE)**
Erfinder: **Stolz, Wolfgang, Dr.**
**Albstrasse 16**
**D-7403 Ammerbuch(DE)**
Erfinder: **Ploog, Klaus, Dr.**
**Furtwänglerstrasse 99**
**D-7000 Stuttgart 1(DE)**
Erfinder: **Nagle, Julien, Dr.**
**Thomson-CSF Domaine de Corbeville B.P. 10**
**F-91401 Orsay(FR)**

(74) Vertreter: **Dipl.-Phys.Dr. Manitz**
**Dipl.-Ing.Dipl.-Wirtsch.-Ing. Finsterwald**
**Dipl.-Phys. Rotermund Dipl.-Chem.Dr. Heyn**
**B.Sc.(Phys.) Morgan**
**Robert-Koch-Strasse 1**
**D-8000 München 22(DE)**

(54) **Lichtemittierendes Bauelement aus Verbindungshalbleiter.**

(57) Ein lichtemittierendes Verbindungshalbleiter-Bauelement mit Mehrfach-Quantentopfstruktur, wie eine Laserdiode oder eine lichtemittierende Diode besitzt aktiven Bereich mit einer abwechselnden Folge von Schichten aus Topfschichtmaterial und aus Sperrschichtmaterial. Die Dicke der Sperrschicht und der benachbarten Topfschichten wird so ausgewählt, daß für eine Ladungsträgerart eine relativ hohe Aufenthaltswahrscheinlichkeit in dem Sperrschichtbereich besteht, während die andere Ladungsträgerart in den Potentialtöpfen lokalisiert ist. Auf diese Weise ist es möglich, die Wahrscheinlichkeit des Auftretens strahlungsloser Auger-Rekombinationsvorgänge zu verringern und so den Schwellstrom zu reduzieren und die Quantenausbeute des Bauelementes zu erhöhen. Dies ist besonders deshalb wichtig, weil Materialsysteme mit kleiner Bandlücke, die bei für Übertragung in optischen Fasern geeigneten großen Wellenlängen lasern, normalerweise schädliche Verhaltenseinflüsse infolge von strahlungslosen Auger-Rekombinationen erleiden, und diese Nachteile können durch die Bemessung der Schichtdicke mit Hinblick auf die beschriebenen Wahrscheinlichkeitsverteilungen wesentlich herabgesetzt werden.

FIG.1

# LICHTEMITTIERENDES BAUELEMENT AUS VERBINDUNGSHALBLEITER

Die vorliegende Erfindung betrifft ein lichtemittierendes Halbleiter-Bauelement. Derartige Bauelemente sind beispielsweise in Form von Halbleiter-Lasern und lichtemittierenden Dioden (LED's) bekannt.

Halbleiter-Laser werden auf vielen Gebieten angewendet. Ein besonderes Interessengebiet sind optische Nachrichtensysteme, bei denen Informationssignale längs optischen Fasern oft über große Entfernungen übertragen werden. Optische Fasern schwächen die Signale mit zunehmender Länge, und es ist wichtig, optische Signale mit Wellenlängen zu verwenden, bei denen Schwächung und Dispersion minimal sind. Bei modernen optischen Fasern liegen die idealen Wellenlängen typischerweise im Bereich von etwa 1,2 bis 1,7 $\mu$m, und es sind zur Zeit Fasern für größere Wellenlängen im Gespräch, gegenwärtig mit Wellenlängen bis zu 4 $\mu$m.

Bei den interessierenden Wellenlängen, d.h. mit Größen über 1,2 $\mu$m, ist die Auswahl von lichtemittierenden Halbleiterbauelementen auf Materialien begrenzt, bei denen strahlungslose Auger-Rekombinationseffekte die Bauelementeigenschaften nachteilig beeinflussen. Damit können GaAs/AlGaAs-Laser, bei denen strahlungslose Auger-Rekombinationseffekte nicht auftreten, bei diesen Wellenlängen nicht verwendet werden.

Bei Halbleiterbauelementen treten strahlende Übergänge auf, wenn ein Elektron im Leitungsband mit einem Loch im Valenzband kombiniert.

Bei Halbleiterbauelementen, die bei größeren Wellenlängen betrieben werden, werden Halbleiter verwendet, bei denen das Valenzband ein zusammengesetztes Band ist, das aus einem Band für schwere Löcher (heavy hole band), einem Band für leichte Löcher (light hole band) und einem Band für Spinnabgespaltene Löcher(split off band) besteht. Verschiedene sogenannte Auger-Rekombinationsvorgänge wurden identifiziert, bei denen ausnahmslos mindestens drei Partikel beteiligt sind. Diese Vorgänge ergeben die Rekombination eines Elektrons vom Leitungsband mit einem schweren Loch im Valenzband, jedoch ohne Erzeugung eines Photons. Anstatt z.B. anderer gleichzeitig stattfindender Übergänge wird die durch das Elektron verlorene Energie auf ein anderes Elektron übertragen, das sich zu einer Lage mit höherer Energie im Leitungsband bewegt, oder auf ein Loch, das sich vom Band für leichte Löcher zum Band für schwere Löcher bewegt. Da diese Vorgänge ohne begleitende Strahlung stattfinden, stellen sie Verluste dar.

Die Auswirkung dieser Verluste durch strahlungslose Auger-Übergänge ist die Erhöhung des Schwellwertstromes und die Reduzierung der Quantenausbeute des Halbleiterbauelementes. Verringerte Quantenausbeute ist auch bei lichtemittierenden Dioden nachteilig. Um eine ausreichende Signalstärke bei einem Halbleiterlaser oder einer -LED zu erreichen, bei denen strahlungslose Auger-Rekombinationsvorgänge auftreten, ist es nötig, diese Bauelemente mit höheren Stromdichten zu betreiben, und das ist sehr problematisch, da erhöhte Wärmefreisetzung und Verschlechterung der Halbleiterstruktur, d.h. verkürzte Lebenszeit und vorzeitiges Versagen die Folgen sind.

In Anbetracht dieser Probleme besteht die der vorliegenden Erfindung zugrundeliegende Aufgabe darin, Halbleiterlaser und -dioden mit Materialien zu schaffen, bei denen normalerweise strahlungslose Auger-Rekombinationsvorgänge angetroffen werden, jedoch diese Bauelemente so zu strukturieren, daß die durch diese Effekte erzeugten Verluste wesentlich reduziert sind.

Ausgehend von den bekannten Halbleiterlasern oder -lichtemittierenden Dioden mit aktiven Bereichen, die mehrfache Quantentöpfe enthalten, wie beispielsweise in dem Kapitel "Physics of Quantum Well Lasers" von N.K. Dutta in dem Buch Heterojunction Band Discontinuities : Physics and Device Applications, herausgegeben durch Elsevier Science Publishers BV, 1987 oder in dem Aufsatz "Properties of 2-D Quantum Well Lasers" von J. Nagle, S. Hersee, M. Razeghi, M. Krakowski, B. Decremoux und C. Weissbuch in der Zeitschrift "Surface Science" 174 (1986), S. 155 - 162 beschrieben, wird erfindungsgemäß ein lichtemittierendes Verbindungshalbleiter-Bauelement mit einem aktiven Bereich geschaffen, der eine abwechselnde Folge von Schichten aus Topfschichtmaterial einer ersten Verbindung mit einer ersten Bandlücke und Sperrschichtmaterial einer zweiten Verbindung mit einer zweiten Bandlücke größer als die erste Bandlücke umfaßt, wobei die Schichtdicken so gewählt sind, daß eine Quanten-Begrenzung von Ladungsträgern auftritt, und wobei das Topfschichtmaterial Quantentöpfe bildet und das Sperrschichtmaterial eine Sperrschicht zwischen jeweils zwei benachbarten Quantentopfen bildet, so daß mindestens zwei Schichten von Topfschichtmaterial vorhanden sind mit einer dazwischen befindlichen Sperrschicht, wodurch zwei Quantentöpfe mit einer Sperre dazwischen gebildet werden, dadurch gekennzeichnet, daß die Dicke der oder jeder Sperrschicht und der benachbarten Topfschichten so ausgewählt wird, daß für einen Ladungsträgertyp eine relativ hohe Anwesenheitswahrschein lichkeit in dem Sperrbereich existiert, während die anderen Ladungsträger in den Potentialtöpfen lokalisiert sind.

Die der Erfindung zugrundeliegende Idee beruht auf der Erkenntnis, daß strahlungslose Auger-Rekombinationsvorgänge wahrscheinlicher auftreten, wenn die Elektronen im Ortsraum infolge der Quantentopfstruktur in der Nähe der Löcher lokalisiert sind, jedoch die Wahrscheinlichkeit solcher strahlungsloser Vorgänge reduziert werden kann, wenn die Anwesenheitswahrscheinlichkeit der Elektronen in der Sperrschicht erhöht werden kann, wo die Elektronen weiter von den Löchern abgesetzt sind.

Gemäß der Erfindung sinkt der Überlapp zwischen den Elektronen- und Lochwellenfunktionen berechnet nach der Gleichung

$$\text{Überlapp} = \int_{\text{Topfschicht}} \psi_e^* \, \psi_h \, d\tau$$

im Vergleich zu einer Konfiguration, wo sowohl Elektronen als auch Löcher völlig im Quantumtopf lokalisiert sind, um mindestens 10%, vorzugsweise um 16% oder mehr. Dabei ist $\Psi_e$ die Elektronenwellenfunktion und $\Psi_h$ die Lochwellenfunktion.

Eine erste bevorzugte Ausführung des erfindungsgemäßen lichtemittierenden Bauelementes zeichnet sich dadurch aus, daß das Material der Topfschicht $Ga_xIn_{1-x}As$ ist und das Sperrschichtmaterial $Al_yIn_{1-y}As$, und daß die oder jede Sperrschicht eine Dicke im Bereich zwischen 1,5 und 12 nm besitzt und die Topfschichten eine Dicke < etwa 6 nm besitzt, wobei diese Dicke auch der Dicke einer monoatomaren Lage entsprechen kann. Vorzugsweise gilt 0,6 nm ≤ der Dicke jeder Topfschicht ≤ 3 nm und 3 nm ≤ der Dicke jeder Sperrschicht ≤ 12 nm. In der Praxis sind bislang die besten Ergebnisse mit einer Topfschicht-Dicke von 1 nm und einer Sperrschicht-Dicke von 9 nm erreicht worden. Diese Abmessungen schaffen eine Sperrschicht, die ausreichend dünn ist, um die Aufenthaltswahrscheinlichkeit der Elektronen in ihr realistisch zu erhöhen, ergeben jedoch keine so dünne Sperrschichten, daß diese für die Elektronen transparent werden und so die gewünschte Quantentopf-Begrenzung herabsetzen.

Kleine Potentialtopfdicken führen zu einer größeren Verschiebung der quantisierten Energieniveaus für Elektronen im Vergleich zu schweren Löchern und damit zu einem stärkeren Eindringen der Elektronwellenfunktion in die Barriere. Bei Barrierenbreiten im mittleren Bereich führt dies zu einer wesentlichen Erniedrigung des Überlapps zwischen Elektronen-und Lochwellenfunktion. Für dünne Barrieren ergibt sich auch für die Lochwellenfunktion ein Eindringen in die Barriere, während für zu dicke Barrieren Elektronen und Löcher wieder beide nur im Potentialtopf lokalisiert sind.

Bei einem lichtemittierenden Bauelement der genannten Art wird x vorzugsweise mit 0,47 gewählt und y mit 0,48, wodurch das Halbleitermaterial in den verschiedenen Schichten ein an InP-Substrate angepaßtes Gitter aufweist. Die Bauelemente selbst sind erfindungsgemäß vorzugsweise durch Epitaxie-Wachstumsverfahren wie Molekularstrahl-Epitaxie oder metallorganische chemische Dampfabscheidung aufgewachsen worden.

Eine alternative Ausführung beruht auf dem GaInAsP-System (Gallium Indium Arsenid Phosphid-System) und zeichnet sich dadurch aus, daß die Topfschicht aus $Ga_xIn_{1-x}As_yP_{1-y}$ besteht und daß die Sperrschicht aus InP besteht, und das die oder jede Sperrschicht eine Dicke im Bereich zwischen 1,5 nm und 12 nm besitzt und die Topfschichten eine Dicke < etwa 4,5 nm besitzen, wobei diese Dicke auch der Dicke einer monoatomaren Lage entsprechen kann. Bei dieser Ausführung sind die Dimensionen der Schichten vorzugsweise die gleichen wie bei der Ausführung auf Grundlage des Gallium Indium Arsenid/Aluminium Indium Arsenid-Systems.

Darüberhinaus gilt bei dieser Ausführung vorzugsweise $y \simeq 2,2\,x$, wobei x im Bereich zwischen 0 und 1/2.2 liegen kann, wodurch sich wiederum Gitteranpassung ergibt.

Die Erfindung ist jedoch nicht auf Systeme mit angepaßten Gittern beschränkt, sondern kann auch mit gedehnten Gittersystemen (strained layer systems) benutzt werden mit unterschiedlichen Topf- und Sperr-Dicken.

Bei Anwendung des Erfindungskonzeptes auf das GaInAs/AlInAs-Materialsystem hat es sich als möglich erwiesen, den Auger-Rekombinationskoeffizienten von Werten, die bei einer Standard-Quantentopf-Struktur etwa $4 \times 10^{-29}$ $cm^6/s$ betragen, auf unter $3,5 \times 10^{-29}$ $cm^6/s$ zu verringern, und es haben ausgeführte Versuche Werte von unter $3 \times 10^{-29}\,cm^6/s$ bei der gleichen Emissionswellenlänge ergeben. Diese Reduzierung hat einen wesentlichen Vorteil mit Bezug auf niedere Grenzströme und höhere Quantenausbeuten.

Das lichtemittierende Bauelement kann, wie vorher erwähnt, entweder als eine lichtemittierende Diode aufgebaut sein, oder es kann mit reflektierenden Endflächen versehen werden, um Laserwirkung zu erzeugen.

Die Erfindung wird nachfolgend anhand der Zeichnung beispielsweise näher erläutert; in dieser zeigt:

Fig. 1 eine schematische Darstellung eines Doppel-Quantentopf-Lasers erfindungsgemäßer Art auf Grundlage des GaInAs/AlInAs-Systems,

Fig. 2A ein Bandschema für den aktiven Bereich eines Doppel-Quantentopf-Lasers nach dem Stand der Technik, d.h. nicht entsprechend der vorliegenden Erfindung dimensioniert, und

Fig. 2B ein Bandschema für den aktiven Bereich des Halbleiterlasers nach Figur 1, d.h. eines Doppel-Quantentopf-Halbleiterlasers, der entsprechend der vorliegenden Erfindung dimensioniert ist,

Fig. 2C ein gleichartiges Diagramm für einen Mehrfach-Quantentopf-Laser mit sechs Quantentopfschichten und fünf Sperrschichten im aktiven Bereich,

Fig. 3 eine schematische Darstellung eines Halbleiter-Lasers erfindungsgemäßer Art auf Grundlage des InGaAsP/InP-Systems, und

Fig. 4A, B und C schematische Darstellungen dreier unterschiedlicher Band/Band-Auger-Rekombinationsvorgänge.

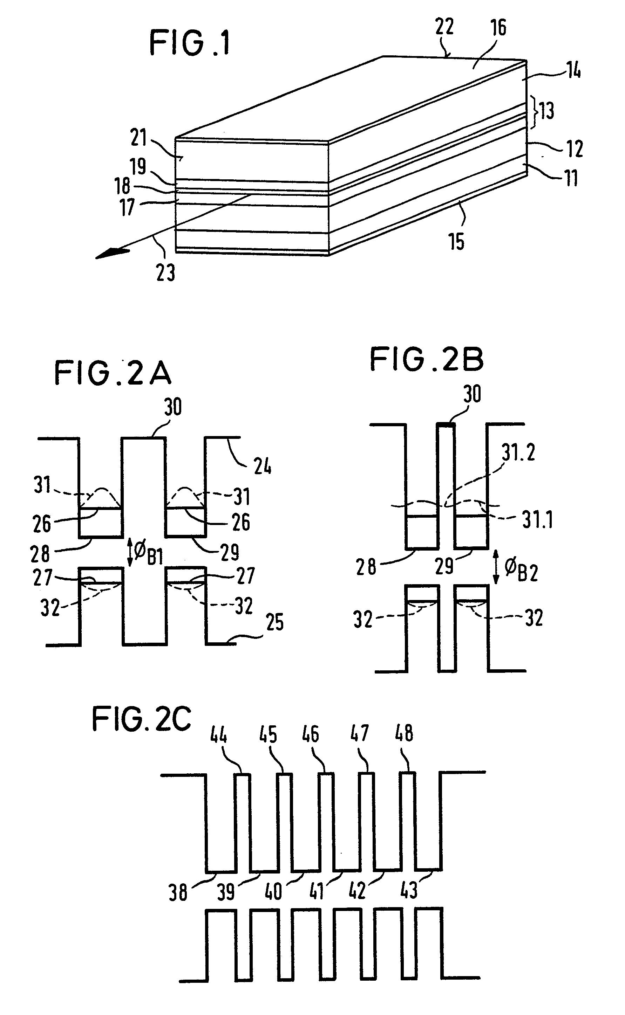

Zunächst ist in Fig. 1 eine schematische Darstellung eines Verbindungs-Halbleiter-Lasers auf Grundlage des Gallium Indium Arsenid/Aluminium Indium Arsenid Systems zu sehen. Der Laser enthält:

ein N-Indium-Phosphid-Substrat 11,

eine Schicht 12 von darauf aufgewachsenem, z.B. N-Indium-Phosphid, mit einer Dicke von typischerweise 1 $\mu$m, einen aktiven Bereich 13, der eine Doppel-Quantentopf-Struktur definiert, eine weitere Indium-Phosphid-Schicht 14, diesmal P-leitend und wieder mit einer Dicke von 1 $\mu$m, und erste bzw. zweite Kontakte 15 und 16, die jeweils an dem Substrat bzw. der oberen Indium-Phosphid-Schicht angebracht sind.

Der aktive Bereich 13 umfaßt erste und zweite Topfschichten 17 und 19 aus $Ga_xIn_{1-x}As$, wobei x typischerweise 0,47 beträgt, und eine Sperrschicht 18 aus $Al_xIn_{1-y}As$, die dazwischen eingeschlossen ist, mit y von typischerweise 0,48. Die Schichten 17 und 19 besitzen eine Dicke von je 1 nm und die Schicht 18 eine Dicke von 9 nm.

Die gesamte Struktur ist durch Epitaxie-Aufwachsverfahren wie Molekularstrahl-Epitaxie aufgewachsen, außer den Kontaktbereichen 15 und 16. Die Endflächen 21 und 22 des Halbleiter-Laserbauelementes sind so durch Spalten hergestellt, daß sie reflektieren. Im Betrieb wird Energie durch Anlegen einer entsprechenden Spannung über die Kontakte 15 und 16 zugeführt und über dem Schwellenstrom wird Laserlicht mit einer Spitzen-Wellenlänge von circa 1,5 $\mu$m in Richtung des Pfeiles 23 infolge angeregter Strahlungsemission emittiert. Ein gleichartiger Aufbau kann für eine lichtemittierende Diode verwendet werden, jedoch müssen hier die Flächen 21 und 22 nicht speziell reflektierend sein.

Die grundlegende Schichtfolge des Doppelquantentopf-Halbleiterlasers nach Figur 1 ist in Verbindung mit Gallium Arsenid/Aluminium Gallium Arsenid-Doppelquantentopf-Lasern an sich bekannt, und Figur 2A zeigt ein typisches Bandschaubild für den aktiven Bereich eines solchen Lasers.

Es ist hier ein Leitungsband 24 und ein Valenzband 25 vorhanden. Ein quantisierter Energiepegel 26 besteht für Elektronen im Leitungsband, und ein quantisierter Energiepegel 27 für Löcher im Valenzband. Diese quantisierten Energiepegel sind in den zwei Quantentöpfen 28 und 29 der Doppelquantentopf-Struktur angeordnet. Zwischen diesen zwei Quantentöpfen 28, 29 befindet sich eine durch die Sperrschicht 18 gebildete Sperre 30. Die Bandlücke ist mit $\emptyset_{B1}$ bezeichnet.

Die gestrichelten Linien 31 zeigen die normalisierte Wahrscheinlichkeitsverteilung für die räumliche Anordnung von Elektronen in den Potentialtöpfen 28 und 29. Die gestrichelten Linien 32 zeigen die entsprechende Verteilung für Löcher im Valenzband, jedoch ist die Verteilungskurve 32 etwas flacher infolge der unterschiedlichen Beweglichkeit der Löcher zu der der Elektronen.

Figur 2B zeigt das gleiche Bandschaubild für den erfindungsgemäßen Halbleiterlaser, und es ist die gleiche Doppelquantentopfstruktur ohne weiteres ersichtlich. Die spezielle Auswahl für die Schichtdicken der Bereiche 17, 18 und 19 ergibt jedoch eine abgewandelte Verteilungskurve 31.1 für Elektronen, und aus dem Abschnitt 31.2 dieser Verteilungskurve ist zu sehen, daß eine begrenzte Wahrscheinlichkeit besteht, daß einige dieser Elektronen in der Sperre 30 anzutreffen sind. Die Verteilung der Löcher im Valenzband ist jedoch im großen und ganzen gegenüber der in Figur 2A gezeigten ungeändert, und deshalb sind diese Verteilungen mit der gleichen Bezugszahl 32 bezeichnet. Das Bandschaubild 2B bezieht sich auf Material mit einer größeren relativen Bandlücke $\emptyset_{B2}$ als die Bandlücke $\emptyset_{B1}$ nach Figur 2A, und die Erfindung ist insbesondere auf solche Materialien gerichtet, da hier die Wellenlänge der Laserwirkung größer ist. Wie bereits erwähnt, ist dies für eine Übertragung mit geringeren optischen Verlusten längs optischer Fasern erwünscht, kann jedoch in der Praxis nur mit Materialsystemen wie dem GaInAsP/InP-Materialsystem bei dem Halbleiterlaser von Figur 1 erreicht werden. Bei diesen Materialien stellen Verluste durch strahlungslose Auger-Rekombination ein Problem dar. Bei der speziellen erfindungsgemäßen Dimensionierung der Schichten des aktiven Bereiches kann die Wahrscheinlichkeit derartiger strahlungsloser Auger-Übergänge jedoch wesentlich aus den angeführten Gründen reduziert werden, d. h. infolge der Tatsache, daß die räumliche Trennung der im Sperrbereich vorhandenen Elektronen von den im Valenzband lokalisierten Löchern die Wahrscheinlichkeit derartiger strahlungsloser Übergänge reduziert.

Obwohl die Wahrscheinlichkeit strahlungserzeugender Übergänge auch etwas verringert ist, ist jedoch die Wahrscheinlichkeitsabnahme strahlungserzeugender Übergänge wesentlich geringer als die Wahrscheinlichkeitsabnahme strahlungsloser Auger-Übergänge, da die ersteren einem linearen, die letzteren einem quadratischen Gesetz folgen.

Figur 2C zeigt, daß der aktive Bereich nicht auf zwei Quantentöpfe beschränkt werden muß, da jede Anzahl von Quantentöpfen möglich ist, und Figur 2C zeigt ein Ausführungsbeispiel mit sechs Quantentöpfen 38, 39, 40, 41, 42 und 43, die jeweils abwechseln mit Sperren 44, 45, 46, 47 und 48. Jedes Paar Quantentöpfe, z. B. 38 und 39 mit der dazwischenliegenden Sperre 44 kann als äquivalent zu den Quantentöpfen 28, 29 mit dazwischenliegender Sperrschicht 30 nach Figur 2B angesehen werden. Allgemein gesprochen werden n-1 Sperrschichten und n Quantentöpfe vorhanden sein.

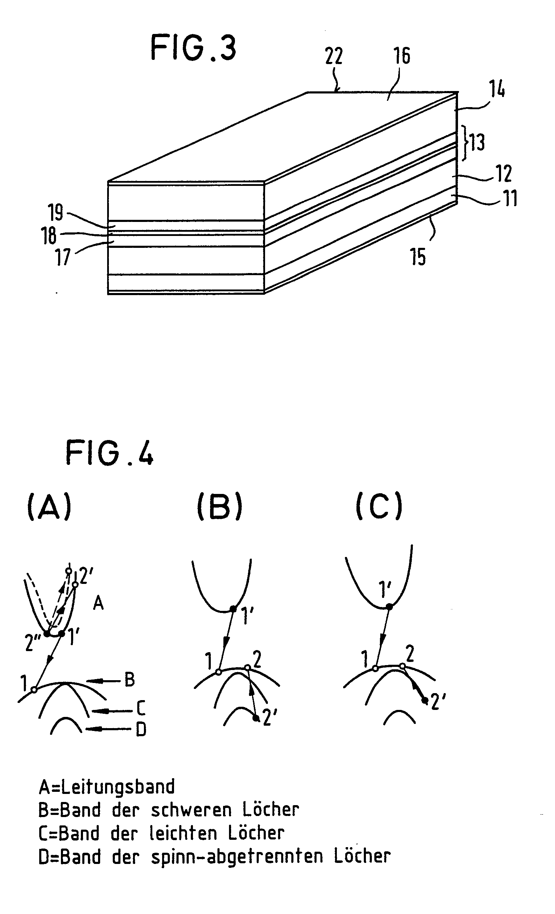

Figur 3 zeigt eine weitere Halbleiter-Laserstruktur, die vom Gesichtspunkt ihrer Schichtfolgen identisch zu der nach Figur 1 ist, und deshalb sind die einzelnen Schichten mit den gleichen Bezugszeichen bezeichnet. Das Halbleiterbauelement nach Figur 3 ist jedoch auf Grundlage des Gallium Indium Arsenid Phosphid/Indium Phosphid-Materialsystems auf gebaut. Insbesondere ist hier die Schicht 11 wiederum ein Indium-Phosphidsubstrat mit N-Leitung. Die Schicht 12 ist eine weitere Schicht aus N-IndiumPhosphid, die auf das Substrat aufgewachsen ist und zur Verleihung von N-Leitung dotiert ist; sie kann jedoch auch undotiert sein. In jedem Fall ist die Schicht 12 typischerweise 1 $\mu$m dick. In dem aktiven Bereich umfassen die beiden Schichten 17 und 19 beide ein $Ga_xIn_{1-x}As_yP_{1-y}$-Material, wobei y $\approx$2,2x. Die Schichten 17 und 19 besitzen Schichtdicken von 4 nm. Die Sperrschicht 18 umfaßt in dieser Ausführung Indiumphosphid mit einer Sperrschichtdicke von ebenfalls 4 nm. Die Schicht 14 umfaßt P-Indiumphosphid und wiederum ist das Bauelement mit metallischen Kontaktschichten 15 und 16 und durch Spaltung hergestellten reflektierenden Flächen 21 und 22 versehen.

Die Bandstruktur ist hier nicht dargestellt, da es sich im wesentlichen um die gleiche Bandstruktur wie in Figur 2A handelt, wenn auch unterschiedliche Bandlücken infolge der anderen Materialzusammensetzung vorhanden sind.

Schließlich erklärt Figur 4 schematisch drei unterschiedliche strahlungslose Auger-Rekombinationsmechanismen, die in einem Verbindungshalbleiter-Bauelement nach Figuren 1 oder 3 auftreten können.

In Figur 4 ist die Bandstruktur eines typischen Halbleiters dargestellt. Das Valenzband besteht aus einem Band schwerer Löcher, einem Band leichter Löcher und einem Band spinn-abgetrennter Löcher. In der in Figur 5 linken Skizze rekombiniert ein Elektron 1' mit einem Loch 1, jedoch erzeugt die freigesetzte Energie kein Photon, sondern regt stattdessen ein weiteres Elektron 2 in einen angeregten Zustand 2' an, wobei das Elektron auch in ein höheres Unterband entsprechend der gestrichelten Linie gestoßen werden kann. Im mittleren Diagramm rekombiniert ein Elektron 1' strahlungslos mit einem Loch 1, und gleichzeitig bewegt sich ein Loch 2 zu einem energiereicheren Loch-Zustand 2' im Split-off Band. In der rechten Skizze rekombiniert wieder das Elektron 1' mit einem Loch 1 und die freigesetzte Energie wird auf ein Loch 2 übertragen, das sich zu einer Lage 2' höherer Energie in dem Band leichter Löcher bewegt.

## Ansprüche

1. Lichtemittierendes Verbindungshalbleiter-Bauelement mit einem aktiven Bereich aus einer abwechselnden Folge von Schichten aus Topfschichtmaterial einer ersten Verbindung mit einer ersten Bandlücke und Sperrschichtmaterial einer zweiten Verbindung mit einer zweiten Bandlücke, die größer als die erste Bandlücke ist, wobei die Schichtdicken so ausgewählt sind, daß Quantenbeschränkung von Ladungsträgern auftritt, das Material der ersten Verbindung Quantentöpfe bildet und das Sperrschichtmaterial eine Sperre zwischen benachbarten Paaren von Quantentöpfen bildet, und mindestens zwei Topfschicht-Materialschichten mit mindestens einer dazwischen angeordneten Sperrschicht vorhanden sind, so daß zwei Quantentöpfe mit einer dazwischenliegenden Sperre gebildet sind,
dadurch gekennzeichnet,
daß die Dicke der oder jeder Sperrschicht und der benachbarten Topfschichten so ausgewählt ist, daß für einen Ladungsträgertyp eine relativ hohe Aufenthaltswahrscheinlichkeit in dem Sperrbereich existiert, während die Ladungsträger des anderen Typs in den Potentialtöpfen lokalisiert sind.

2. Lichtemittierendes Bauelement nach Anspruch 1,
dadurch gekennzeichnet,
daß der Überlapp zwischen den Elektronen- und Lochwellenfunktionen im Vergleich zu einem Zustand in dem die Aufenthaltswahrscheinlichkeit von Elektronen und Löchern im jeweiligen Quantentopf 1 beträgt, um mindestens 10% und vorzugsweise um 16% oder mehr reduziert ist.

3. Lichtemittierendes Bauelement nach Anspruch 1 oder Anspruch 2,
dadurch gekennzeichnet,
daß das Topfschichtmaterial aus $Ga_xIn_{1-x}As$ und das Sperrschichtmaterial aus $Al_yIn_{1-y}As$ besteht und daß die oder jede Sperrschicht eine Dicke im Bereich zwischen 1,5 nm und 12 nm besitzt und die aktiven Schichten eine Dicke kleiner als 6 nm besitzen, wobei diese Dicke auch der Dicke einer monoatomaren Lage entsprechen kann.

4. Lichtemittierendes Bauelement nach Anspruch 3,
dadurch gekennzeichnet,
daß die Dicke der Topfschichten im Bereich 0,6 nm bis 3 nm und die Dicke jeder Sperrschicht im Bereich 3 nm bis 12 nm liegt.

5. Lichtemittierendes Bauelement nach Anspruch 3 oder Anspruch 4,
dadurch gekennzeichnet,
daß die Dicke der Topfschicht im wesentlichen 1 nm und die Dicke der Sperrschicht im wesentlichen 9 nm beträgt.

6. Lichtemittierendes Bauelement nach Anspruch 2,
dadurch gekennzeichnet,
daß $x = 0,47$ und $y = 0,48$ ist.

7. Lichtemittierendes Bauelement nach Anspruch 1 oder Anspruch 2,
dadurch gekennzeichnet,
daß das Topfschichtmaterial aus $Ga_xIn_{1-x}As_yP_{1-y}$ und das Sperrschichtmaterial aus InP besteht und daß die oder jede Sperrchicht eine Dicke im Bereich zwischen 1,5 nm und 12 nm besitzt und die Topfschichten eine Dicke kleiner als etwa 4,5 nm besitzen, wobei diese Dicke auch der Dicke einer monoatomaren Lage entsprechen kann.

8. Lichtemittierendes Bauelement nach Anspruch 7,
dadurch gekennzeichnet,
daß $y = 2,2x$ ist und x im Bereich von 0 bis 1/2,2 liegen kann.

9. Lichtemittierendes Bauelement nach Anspruch 1 oder Anspruch 2,
dadurch gekennzeichnet,
daß das Bauelement ein System mit gedehnten Schichten (strained layers) aufweist mit unterschiedlichen Dicken von Topf- und Sperrschichten.

10. Lichtemittierendes Bauelement nach Anspruch 3,
dadurch gekennzeichnet,
daß der Koeffizient strahlungsloser Auger-Rekombinationen unter $3,5 \times 10^{-29}\,cm^6/s$ und vorzugsweise unter $3 \times 10^{-29}\,cm^6/s$ liegt bei einer Struktur auf Grundlage von z.B. (GaIn)As/(AlIn)As, das bei 10K eine Emissionswellenlänge von 1,24 μm besitzt.

11. Lichtemittierendes Bauelement nach einem der vorangehenden Ansprüche,
dadurch gekennzeichnet,
daß es als lichtemittierende Diode aufgebaut ist.

12. Lichtemittierendes Bauelement nach einem der vorangehenden Ansprüche 1 bis 10,
dadurch gekennzeichnet,
daß es zur Erzeugung von Laserwirkung reflektierende Endflächen besitzt und als Halbleiterlaser gestaltet ist.

Neu eingereicht / N
Neuvellement dé

FIG.1

FIG.2A

FIG.2B

FIG.2C

Neu eingereicht / f
Nouvellement déposée

# FIG.3

# FIG.4

## (A)          (B)          (C)

A=Leitungsband
B=Band der schweren Löcher
C=Band der leichten Löcher
D=Band der spinn-abgetrennten Löcher